Europäisches Patentamt

European Patent Office

Office européen des brevets

(11) Numéro de publication: **0 262 030 B1**

# FASCICULE DE BREVET EUROPEEN

(45) Date de publication de fascicule du brevet:
**17.07.91**

(51) Int. Cl.5: **H01L 21/441**, H01L 21/425,
H01L 29/22, H01L 31/02,
H01L 31/10

(21) Numéro de dépôt: **87402053.0**

(22) Date de dépôt: **15.09.87**

(54) Procédé de réalisation d'une prise de contact électrique sur un substrat en HgCdTe de conductivité P et application à la fabrication d'une diode N/P.

(30) Priorité: **19.09.86 FR 8613141**

(43) Date de publication de la demande:
**30.03.88 Bulletin 88/13**

(45) Mention de la délivrance du brevet:
**17.07.91 Bulletin 91/29**

(84) Etats contractants désignés:
**DE GB IT**

(56) Documents cités:
**EP-A- 0 007 668**
**EP-A- 0 062 367**
**US-A- 4 439 912**
**US-A- 4 447 291**

**CONFERENCE EUROPEENNE SUR LES COMMUNICATIONS OPTIQUES, Cannes, 21-24 septembre 1982, pages 389-393; G. PICHARD et al.: "Photodiodes HgCdTe pour télécommunications par fibres optiques à grande distance"**

(73) Titulaire: **COMMISSARIAT A L'ENERGIE ATO-MIQUE Etablissement de Caractère Scientifique Technique et Industriel**
**31/33, rue de la Fédération**
**F-75015 Paris(FR)**

(72) Inventeur: **Bory, Cécile**
**9, rue Fetola Le Fontanil**
**F-38120 Saint Egrève(FR)**
Inventeur: **Ouvrier Buffet, Jean-Louis**
**6, Avenue Victor Hugo**
**F-38170 Seyssinet Pariset(FR)**
Inventeur: **Parat, Guy**
**3, Chemin Marceau**
**F-38100 Grenoble(FR)**

(74) Mandataire: **Mongrédien, André et al**
**c/o BREVATOME 25, rue de Ponthieu**
**F-75008 Paris(FR)**

Rank Xerox (UK) Business Services

# Description

La présente invention concerne un procédé de réalisation d'une prise de contact électrique sur un substrat en HgCdTe de conductivité P ainsi qu'une application de ce procédé à la fabrication d'une diode N/P.

L'invention s'applique à tous les dispositifs utilisant une prise de contact sur un substrat en HgCdTe de conductivité P, et notamment aux détecteurs infrarouges utilisant des photodiodes N/P.

L'invention concerne notamment la réalisation de prises de contact sur un substrat en HgCdTe épitaxié sur un support isolant. En effet, dans cette configuration, la surface du substrat sur laquelle les prises de contact peuvent être réalisées est réduite à la face avant du substrat, dans une région de conductivité P ; les prises de contact sont de ce fait de faibles dimensions, et doivent donc être réalisées suivant des procédés d'intégration de la micro-électronique. Mais bien entendu, l'invention s'applique aussi à la réalisation de prises de contact sur un substrat en HgCdTe massif.

De façon connue, pour réaliser une prise de contact électrique sur un substrat, on dépose préalablement une couche isolant sur la face du substrat où la prise de contact doit être réalisée. Cette couche isolante est gravée à travers un masque, par exemple en résine photosensible, par une solution chimique de façon à réaliser une ouverture sur toute l'épaisseur de la couche isolante. Un matériau conducteur est ensuite déposé dans l'ouverture effectuée dans la couche isolante pour réaliser une prise de contact électrique sur le substrat.

Avec ce procédé, la pente de la gravure réalisée dans la couche isolante dépend de la texture et de la rugosité du matériau constituant la couche isolante ainsi que de la composition de la solution chimique. De ce fait, la pente de l'ouverture réalisée dans la couche isolante est généralement abrupte. Aussi, le matériau conducteur déposé dans cette ouverture peut recouvrir de façon discontinue la paroi de l'ouverture et la partie du substrat en regard de l'ouverture, réalisant ainsi un circuit ouvert avec le substrat en HgCdTe.

La prise de contact sur le substrat est encore plus délicate lorsque la couche isolante est constituée de bi-couches par exemple du type SiO$_2$-Si$_3$N$_4$, SiO$_2$-ZnS ou encore CdTe-ZnS. En effet, ces matériaux ne présentent pas la même vitesse de gravure et de ce fait, il y a toujours un des matériaux utilisés pour réaliser la couche isolante qui présente une gravure plus importante que l'autre, conduisant à une ouverture, de pente discontinue.

L'invention a pour but de remédier à ces inconvénients en réalisant une gravure par bombardement ionique de la couche isolante ; ce bombardement ionique permet à la fois de graver les matériaux couramment utilisés pour la réalisation de la couche isolante et de contrôler la pente de l'ouverture réalisée dans la couche isolante.

Cependant, lorsqu'un bombardement ionique atteint un substrat en HgCdTe de conductivité P, la conductivité d'une partie du substrat, affectée par ce bombardement voit sa conductivité P diminuer, sa conductivité pouvant devenir de type N. L'inversion de conductivité d'une partie d'un substrat en HgCdTe de conductivité P par un bombardement ionique est décrit dans le brevet US-A-4 411 732 ; cette inversion conduit à la réalisation d'une jonction N/P sensible notamment aux rayonnements infrarouges. Malheureusement, un contact électrique réalisé sur la partie du substrat affectée par le bombardement ionique n'est pas de caractère ohmique et il est générateur de bruit.

L'invention a donc également pour but de ramener la conductivité de la partie du substrat affectée par le bombardement ionique au moins à sa valeur initiale, et de réaliser un contact électrique sur cette partie P du substrat guérie, ce contact étant de caractère ohmique et moins générateur de bruit.

L'invention a par ailleurs pour but d'appliquer le procédé de réalisation d'une prise de contact sur un substrat en HgCdTe de conductivité P à la fabrication d'une diode N/P.

De façon plus précise, l'invention a pour objet un procédé de réalisation d'une prise de contact électrique sur un substrat en HgCdTe de conductivité P, selon lequel:

- on dépose au moins une couche isolante sur ledit substrat,
- on grave par un bombardement ionique la couche isolante sur toute son épaisseur de façon à réaliser une ouverture dans la couche isolante,
- on effectue un traitement thermique du substrat recouvert par la couche isolante, de façon à au moins compenser la diminution de conductivité P induite par le bombardement ionique dans une partie du substrat en regard de l'ouverture réalisée dans la couche isolante,
- on forme un plot conducteur dans l'ouverture réalisée dans la couche isolante pour réaliser une prise de contact électrique avec la partie du substrat en regard de ladite ouverture.

On entend par gravure par bombardement ionique aussi bien une gravure par plasma de type planaire, assisté par un bombardement ionique qu'une gravure par faisceau d'ions réactifs ou non. Un bombardement ionique présente une énergie de l'ordre de 50 eV à 1000 eV.

La gravure de la couche isolante par bombardement ionique permet d'obtenir une ouverture de pente linéaire, non abrupte, sur toute l'épaisseur de la couche. Par ailleurs, lorsque le bombardement ionique atteint la partie du substrat en regard de l'ouverture réalisée dans la couche isolante, cette partie du substrat voit sa conductivité P diminuer. La profondeur de ladite partie du substrat affectée par le bombardement ionique est bien supérieure à la profondeur de pénétration des ions et elle dépend du temps pendant lequel le substrat a été bombardé.

Ainsi, pour un substrat bombardé pendant 2 minutes, la profondeur de la partie du substrat pour laquelle la conductivité P a diminué est de l'ordre de 15 $\mu$m.

La conductivité P du substrat est due à un taux d'accepteurs autrement dit de lacunes de mercure dans le substrat, supérieur au taux de donneurs résiduels, tels que des défauts ou des impuretés chimiques inhérents au substrat. Lorsque le substrat est bombardé par des ions, la conductivité P de la parti du substrat affectée par ce bombardement diminue. En effet, le bombardement ionique engendre des défauts cristallins, autrement dit, des donneurs qui s'ajoutent aux donneurs résiduels et qui accentuent le caractère N de la partie du substrat affectée par le bombardement.

Par ailleurs, il semblerait que ce bombardement ionique entraîne une diffusion de mercure dans cette partie du substrat, conduisant à une baisse du taux de lacunes de mercure dans ladite partie. Lorsque le taux d'accepteurs présents dans la partie du substrat affectée est supérieur au taux de donneurs, la conductivité de cette partie du substrat reste du type P ; en revanche, lorsque le taux d'accepteurs est inférieur au taux de donneurs, la conductivité de la partie affectée est de type N.

Les défauts cristallins engendrés par le bombardement ionique commencent à disparaître à une température de l'ordre de 150 à 200°C, et la production de lacunes de mercure exige une température supérieure à 200°C pour assurer un dopage suffisamment important au moins de l'ordre de $10^{16}$ lacunes par cm$^3$. Par ailleurs, pour retrouver dans la partie affectée au moins le taux de lacunes présent antérieurement au bombardement ionique, autrement dit au moins le même taux de lacunes que dans le reste du substrat, la température du traitement thermique doit être du même ordre de grandeur que celle ayant fixé le taux de lacunes du substrat.

Aussi, de préférence, le traitement thermique est effectué à une température supérieure à 200°C et égale à la température ayant fixé la conductivité P du substrat.

De façon avantageuse, on effectue un recuit du substrat, avant de déposer la couche isolante, pour ajuster la conductivité P du substrat à une valeur souhaitée, le traitement thermique et le recuit étant effectués à la même température ; la température ayant fixé le taux de lacunes du substrat correspond dans ce cas à la température du recuit.

En effet, en chauffant le substrat, on peut ajuster le taux d'accepteurs présents dans celui-ci à un taux compatible avec par exemple le fonctionnement d'une diode N/P réalisée à partir dudit substrat. Aussi, pour avoir au moins le même taux d'accepteurs dans la partie du substrat en regard de l'ouverture réalisée dans la couche isolante avant le bombardement ionique et après le traitement thermique, le traitement thermique et le recuit doivent être effectués à la même température. En revanche, la durée du traitement thermique est généralement plus courte que la durée du recuit.

La durée du recuit dépend du taux d'accepteurs souhaités dans le substrat et de la vitesse de recombinaison ou éventuellement de création d'accepteurs ; cette durée est par exemple de l'ordre de 10 à 100 heures. La durée du traitement thermique dépend notamment de la vitesse d'élimination des défauts cristallins engendrés par le bombardement ionique, ainsi que du taux d'accepteurs souhaité, ce dernier étant au moins égal à celui du substrat ; la durée de ce traitement thermique est par exemple de l'ordre de 1 minute à 1 heure.

Bien entendu, dans le cas où le substrat utilisé a initialement, c'est-à-dire après élaboration, un taux d'accepteur du même ordre de grandeur que celui souhaité, ce recuit n'est pas effectué et la température du traitement thermique est de préférence supérieure à 200°C et du même ordre de grandeur que la température d'élaboration du substrat correspondant alors à la température ayant fixé la conductivité P du substrat.

Selon un mode préféré de réalisation du procédé, la couche isolante est déposée sous forme d'une première et d'une deuxième couches isolantes.

En effet, l'emploi comme matériau isolant de deux couches isolantes comme par exemple le $SiO_2$ et le $Si_3N_4$, ou le $SiO_2$ et le ZnS ou encore le CdTe et le ZnS permet d'améliorer les propriétés isolantes dudit matériau et éventuellement les propriétés anti-reflets, notamment dans le cas où le substrat est utilisé pour former une photodiode éclairée à partir de la couche isolante.

Pour maîtriser l'inclinaison de la pente de la gravure effectuée dans la couche isolante, lorsque celle-ci est réalisée par bombardement ionique à travers un masque en résine déposée sur ladite couche et comportant une ouverture en regard de l'ouverture à réaliser dans ladite couche, il est avantageux de traiter thermiquement ce masque pour faire fluer ladite résine dans l'ouverture du masque avant de réaliser l'ouverture de la couche isolant. Ce traitement thermique s'effectue à une température de l'ordre de 130°C et permet d'obtenir par exemple un masque ayant une ouverture de pente inclinée par rapport à la normale à la surface de la couche isolante d'environ 30 à 40°.

Le traitement thermique permettant de pallier au moins la baisse de conductivité P de la partie du substrat en regard de l'ouverture réalisé dans la couche isolante peut s'effectuer suivant différents procédés, permettant notamment de s'affranchir d'une exodiffusion importante des constituants du substrat tel que le mercure. On peut effectuer par exemple ce traitement thermique sous atmosphère de mercure, dans une ampoule scellée. On peut aussi déposer sous vide, sur la partie du substrat en regard de l'ouverture réalisée dans la couche isolante, un matériau isolant, celui-ci étant éliminé après ledit traitement thermique. Dans ces deux cas, le taux d'accepteurs est ramené par le traitement thermique au taux initial, c'est-à-dire au taux d'accepteurs présents dans le substrat.

On peut également déposer sous vide sur ladite partie en regard de l'ouverture réalisée dans la couche isolante, un matériau métallique comprenant des atomes à caractère P, pour obtenir après le traitemente thermique, une conductivité P dans ladite partie, supérieure à celle du reste du substrat ; ce matériau est de préférence conservé après ledit traitement thermique pour plus de facilité.

Le matériau métallique constitue un réservoir d'espèces dopantes de caractère P qui diffusent dans ladite partie du substrat, au cours de ce traitement thermique sur une épaisseur de plusieurs microns suivant sa durée. Ce matériau peut par exemple être de l'or ou du cuivre et il est déposé sous forme d'une couche généralement de quelques dizaines de nm d'épaisseur.

Ainsi par exemple pour l'or, un traitement thermique de l'ordre de 10 minutes à environ 350°C permet une diffusion des atomes d'or sur une épaisseur de l'ordre de 10μm.

Dans le cas où un matériau isolant est déposé sur la partie du substrat en regard de l'ouverture réalisée dans la couche isolante, ce matériau est enlevé de façon sélective par rapport à la couche isolante et au substrat après traitement thermique, par exemple par attaque chimique. Ainsi à titre d'exemple, pour enlever un matériau en $SiO_2$, une solution de HF (c'est-à-dire d'acide fluorhydrique) peut être utilisée, cette solution n'altérant ni le HgCdTe, ni la couche isolante par exemple en ZnS.

L'invention a également pour objet un procédé de fabrication d'une diode N/P à partir d'un substrat en HgCdTe de conductivité P selon lequel, successivement:

- on dépose au moins une couche isolante sur ledit substrat,
- on grave par un bombardement ionique la couche isolante sur toute son épaisseur de façon à réaliser une première ouverture dans la couche isolante,
- on effectue un traitement thermique du substrat recouvert par la couche isolante de façon à au moins compenser la diminution de conductivité P induite par le bombardement ionique dans une première partie du substrat en regard de la première ouverture,
- on effectue dans le substrat, traité thermiquement, à travers la couche isolante, une implantation ionique pour former dans le substrat une deuxième partie de conductivité N, distante de la première partie,
- on grave par un bombardement ionique la couche isolante sur toute son épaisseur de façon à réaliser une deuxième ouverture dans la couche isolante en regard de la deuxième partie, et
- on forme des plots conducteurs dans les première et deuxième ouvertures de la couche isolante, pour réaliser une prise de contact électrique avec chacune desdites première et deuxième parties du substrat en regard desdites ouvertures.

Ce procédé de fabrication d'une diode N/P est une application du procédé de réalisation d'une prise de contact électrique sur un substrat en HgCdTe de conductivité P décrit précédemment, il a donc notamment les mêmes caractéristiques que celui-ci. La couche isolante peut être en particulier constituée de plusieurs couches empilées.

La deuxième partie de conductivité N provient des défauts cristallins engendrés par l'implantation ionique. L'implantation ionique s'effectue à des énergies de l'ordre de 50 keV à 200 keV. Par ailleurs, les défauts engendrés par l'implantation ionique commençant à se guérir à partir de 150°C, le traitement thermique du procédé de fabrication de la diode N/P est donc obligatoirement effectué avant la création de cette deuxième partie.

De façon avantageuse, on effectue également un recuit du substrat avant de déposer la couche isolante pour ajuster la conductivité P du substrat à une valeur souhaitée, le traitement thermique et le recuit étant effectués à la même température.

Par ailleurs, le traitement thermique est effectué de préférence à une température supérieure à 200°C et égal à la température ayant fixé la conductuvité P du substrat, c'est-à-dire à la température du recuit dans le cas où un recuit est effectué et à la température d'élaboration du substrat dans le cas contraire.

Ce traitement thermique est effectué de préférence après avoir déposé sous vide, sur la première partie du substrat en regard de la première ouverture réalisée dans la couche isolante, un matériau métallique comprenant des atomes à caractère P, pour obtenir une conductivité P dans ladite partie du substrat, supérieure à celle du reste du substrat, ledit matériau étant de préférence conservé après ledit traitement thermique.

De préférence, la première ouverture de la couche isolante étant réalisée par bombardement ionique à travers un masque en résine déposée sur ladite couche, comportant une ouverture en regard de la première ouverture à réaliser dans ladite couche, on traite thermiquement ledit masque pour faire fluer la résine dans l'ouverture du masque, avant de réaliser ladite première ouverture.

De même, la deuxième ouverture de la couche isolante étant réalisée par bombardement ionique à travers un masque en résine déposée sur ladite couche, comportant une ouverture en regard de la deuxième ouverture à réaliser dans ladite couche, on traite thermiquement de façon avantageuse ledit masque pour faire fluer la résine dans l'ouverture dudit masque, avant de réaliser ladite deuxième ouverture.

D'autres caractéristiques et avantages de l'invention ressortiront mieux de la description qui va suivre donnée à titre purement illustratif et non limitatiff en référence aux figures annexées dans lesquelles :
- les figures 1a-1i représentent schématiquement les étapes principales d'un exemple de réalisation d'une diode N/P avec prise de contact sur un substrat de conductivité P, conformément à l'invention, et
- la figure 2 représente schématiquement un autre exemple de diode N/P obtenu selon le procédé de fabrication de l'invention et comportant deux couches isolantes.

Sur la figure 1a est représenté un substrat 1 en HgCdTe de conductivité P épitaxié sur un support isolant 5 tel qu'un support en CdTe. Sur la face supérieure du substrat, c'est-à-dire sur la face du substrat opposée à celle en regard du support isolant, est déposée une couche isolante 3 par exemple en $SiO_2$ ou en ZnS ou encore en $Si_3N_4$ jouant éventuellement le rôle de couche anti-reflet. Cette couche isolante est déposée par exemple par pulvérisation sur une épaisseur d'environ 100 à 1000 nm.

De préférence, le substrat 1 a subi préalablement au dépôt de la couche 3 un recuit permettant d'ajuster le taux d'accepteurs, autrement dit de lacunes dans le substrat, à une valeur souhaitée compatible avec le fonctionnement d'une diode N/P réalisée à partir de ce substrat. Cette valeur est généralement de l'ordre de $10^{16}$ à $10^{17}$ lacunes par $cm^3$. Un recuit d'une température de 350° C permet d'avoir environ $8.10^{16}$ accepteurs ou lacunes/$cm^3$.

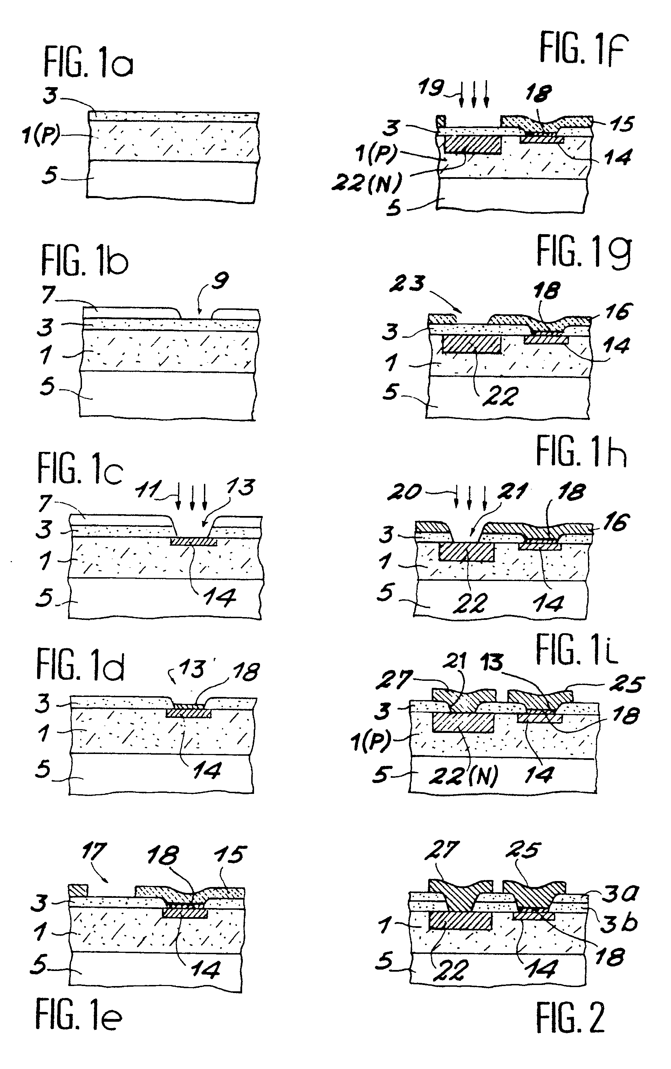

On dépose ensuite sur la couche isolante 3, une couche de résine photosensible, que l'on insole et que l'on développe de façon à réaliser dans cette couche une ouverture 9 par exemple de l'ordre de 4 à 10$\mu$m en regard de la partie de la couche isolante 3 à graver (figure 1b).

Afin que le masque 7 ainsi réalisé présente une ouverture 9 à paroi inclinée, on le traite thermiquement. La résine chauffé coule le long de la paroi de l'ouverture 9, qui présente une pente inclinée par rapport à la normale d'un angle d'environ 30 à 40° (figure 1b). Par exemple, pour la résine commercialisée sous le nom de SHIPLEY 1350H, ce traitement thermique est effectué à une température de l'ordre de 130° C pendant environ 1 minute.

Une fois cette étape réalisée, on grave la couche isolante 3 sur toute son épaisseur pour former une ouverture 13 par un bombardement ionique 11 (figure 1c), par exemple par un usineur ionique, tel que le dispositif commercialisé sous le nom de "MICROETCH" produit par la Société VEECO INSTRUMENTS. Les ion s utilisés sont des ions d'argon ou des ions d'un mélange $Ar + O_2$ (ces derniers étant notamment utilisés pour réaliser des prises de contact en pente) et les énergies du faisceau d'ions varient de 100 eV à 1 keV. Les valeurs de courant et d'énergie utilisés avec un tel dispositif sont par exemple de 500 nA/$cm^2$ et 500 eV.

Dans ces conditions, la gravure de la couche 3 effectuée à travers le masque 7 dont la pente de l'ouverture 9 est de 30 à 40°, conduit à une ouverture 13 ayant une pente d'environ 50 à 60° par rapport à la normale à cette couche. Le masque 7 est enlevé par des techniques classiques après réalisation de l'ouverture 13 qui constituera ultérieurement un trou de contact électrique.

La partie du substrat 14 en regard de l'ouverture 13 de la couche isolante, affectée par ce bombardement ionique, voit sa conductivité P diminuer du fait notamment de la création de défauts cristallins par le bombardement ionique. La profondeur de cette partie 14 est par exemple de l'ordre de 1 $\mu$m. Lorsque le taux d'accepteurs présents après ce bombardement ionique dans la partie 14 est inférieur au taux de donneurs, la conductivité de la partie 14 est comme on l'a vu précédemment de type N.

Pour pallier au moins la baisse de conductivité P induite par le bombardement ionique, on effectue alors un traitement thermique du substrat recouvert par la couche isolante 3. La température de ce traitement thermique est de préférence supérieure à 200° C pour éliminer l'ensemble des défauts cristallins engendrés par le bombardement ionique dans la partie 14 et pour créer des lacunes lorsque ce bombardement ionique a entraîné une diffusion de mercure, autrement dit une baisse du taux d'accepteurs, dans la partie 14. En outre, cette température est égale à la température ayant permis d'ajuster la valeur initiale du taux d'accepteurs présents dans le substrat pour avoir au moins le même taux d'accepteurs dans la partie 14 soit égale à 350° C. Le taux de donneurs restants après ce traitement est constitué à nouveau par les donneurs résiduels.

Ce traitement thermique est réalisé par exemple après avoir déposé sous vide un matériau 18, sur la partie 14 du substrat et dans l'ouverture 13 réalisée dans la couche isolante 3, comme illustré sur la figure 1d.

Ce matériau 18 peut être constitué d'un matériau métallique tel que de l'or ou du cuivre ou de n'importe quel métal comprenant des espèces dopantes à caractère P ou bien d'un matériau isolant tel que le $SiO_2$. Il est déposé sous forme d'une couche par exemple de quelques dizaines de nm d'épaisseur.

Lorsque le matériau 18 est isolant, le traitement thermique du substrat recouvert par ce matériau permet d'éviter une exodiffusion de mercure, d'éliminer les défauts cristallins dûs au bombardement ionique et de créer d'éventuelles lacunes pour ramener la conductivité de la partie 14 à la conductivité du reste du substrat. Le même résultat peut être obtenu en effectuant le traitement thermique sous atmosphère de mercure.

Lorsque le matériau 18 est métallique, le traitement thermique effectué avec ce matériau métallique permet en plus des propriétés précédentes de diffuser une espèce dopante de caractère P, sur une profondeur de plusieurs micromètres suivant la durée du traitement, réalisant ainsi une partie 14 surdopée, c'est-à-dire dont le taux d'accepteurs est supérieur à celui du reste du substrat. La profondeur de cette partie surdopée est choisie par exemple entre 1 $\mu$m et 5 $\mu$m.

Après traitement thermique, lorsque le matériau 18 est isolant, il est éliminé de façon sélective par rapport au substrat 1 et à la couche isolante 3, par exemple par attaque chimique. Dans le cas où la couche isolante 3 est du ZnS, on élimine par exemple le matériau 18 par une solution HF, lorsque celui-ci est en $SiO_2$.

En revanche, après traitement thermique, lorsque le matériau 18 est métallique, celui-ci est de préférence conservé.

De façon avantageuse e, pour réaliser une diode N/P, on utilise un matériau 18 métallique. De ce fait, sur le reste des figures, on a conservé le matériau 18, celui-ci étant considéré métallique.

Pour réaliser une diode N/P, il faut par ailleurs réaliser une implantation ionique dans une partie 22 du substrat P distante de la partie 14 (figure 1f), permettant d'obtenir une conductivité N dans cette partie 22, et graver à nouveau la couche isolante 3

pour réaliser une prise de contact sur la partie 22.

Comme illustré sur la figure 1e, on dépose donc tout d'abord sur la couche isolante 3 un deuxième masque 15 tel qu'une couche de résine photosensible que l'on insole et que l'on développe de façon à obtenir une ouverture 17 par exemple de l'ordre de 10 à 100 $\mu$m dans cette résine, située en dehors de la partie 14 du substrat.

Le masque 15 ainsi réalisé permet d'effectuer, à travers la couche 3, une implantation ionique 19 dans la partie 22 du substrat 1 en regard de l'ouverture 17, de façon à obtenir une partie 22 de conductivité N (figure 1f). Le taux de donneurs présents alors dans la partie 22 est supérieur au taux de donneurs résiduels et au taux d'accepteurs du substrat. La profondeur de la partie 22 est choisie par exemple de l'ordre de 5 $\mu$m.

Les ions implantés sont des ions légers tels que les ions de bore ou de phosphore, les doses d'implantation varient de $10^{13}$ ions/cm² à $10^{16}$ ions/cm² et les énergies d'implantation varient de 50 keV à 200 keV.

Après cette étape, on enlève le masque d'implantation 15 par des techniques classiques et on forme sur la couche isolante 3 un troisième masque 16 tel qu'une couche de résine photosensible que l'on insole et que l'on développe de façon à obtenir une ouverture 23 par exemple de l'ordre de 4 à 10 $\mu$m, dans ladite couche de résine, cette ouverture 23 plus petite que celle du masque 15 étant en regard de la partie 22 du substrat (figure 1g). Ce masque 15 représente l'image du trou de contact à former dans la couche isolante 3 en regard de la partie 22 ; il fixe les dimensions et l'emplacement de ce trou de contact.

De même que pour le masque 7, un traitement thermique du masque 16 peut également être effectué pour faire fluer la résine dans l'ouverture 23 du masque 16 de façon à obtenir une ouverture 23 de pente inclinée, par rapport à la normale, d'un angle d'environ 30 à 40°.

L'étape suivante consiste à ouvrir la partie de la couche isolante 3 intercalée entre cette partie 22 et l'ouverture 23 du masque 16. Cette gravure est effectuée à travers le masque 16 par un bombardement ionique 20 sans inversion de conductivité pour la partie 22, du fait que cette partie est déjà de conductivité N (figure 1h). On réalise donc un trou de contact 21 dans la couche isolante, de pente inclinée de 50 à 60° par rapport à la normale, si la gravure est effectuée dans les mêmes conditions que la gravure de l'ouverture 13 décrite précédemment. Après formation de l'ouverture 21, on enlève le masque 16 par des techniques classiques.

La dernière étape du procédé de réalisation de la diode N/P (figure 1i) consiste à former deux plots conducteurs 25, 27 respectivement dans les ouvertures 13 et 21 de la couche isolante 3, afin de réaliser des prises de contacts électriques avec les parties 14 et 22 du substrat 1 de conductivité respectivement P et N. Pour cela, on dépose par pulvérisation cathodique sur l'ensemble de la couche isolante 3, une couche conductrice continue constituée par exemple de deux couches empilées respectivement de Cr et de Au, puis on grave ladite couche pour obtenir deux plots conducteurs respectivement dans les ouvertures 13 et 21 réalisant deux prises de contacts respectivement avec les parties 14 et 22 du substrat, ces deux prises de contact étant isolées entre elles.

Bien entendu, lorsque le matériau 18 est métallique et conservé, il est intercalé entre le plot référencé 25 et la surface de la partie 14 ; dans ce cas la prise de contact avec la partie 14 est constituée par le matériau 18 et le plot 25. En revanche, lorsque le matériau 18 est éliminé, seul le plot 25 constitue la prise de contact avec la partie 14.

La figure 2 représente une variante d'une diode N/P réalisée par le procédé de fabrication conforme à l'invention. Cette diode diffère de la diode représentée figure 1i, par une couche isolante 3 constituée par la superposition de deux couches isolantes 3a et 3b, par exemple en $SiO_2$ et en $Si_3N_4$ ou en $SiO_2$ et en ZnS ou encore en CdTe et en ZnS, les différentes étapes de réalisation de cette diode étant les mêmes que celles décrites précédemment. Les deux couches isolantes confèrent une meilleure isolation électrique ainsi que des propriétés anti-reflets, ce qui est intéressant dans le cas de détection infra-rouge.

Sur ces figures, on a choisi de représenter un substrat en HgCdTe épitaxié sur un matériau isolant pour réaliser des prises de contact sur la face avant du substrat. Cet exemple n'est bien entendu pas limitatif. On peut également réaliser des prises de contact sur un substrat massif suivant les mêmes étapes de réalisation. De plus, ces figures représentent la fabrication d'une diode N/P mais bien entendu le procédé de réalisation d'une prise de contact sur un substrat en HgCdTe de conductivité P peut s'appliquer à d'autres dispositifs, et notamment à ceux comprenant des régions de type N réalisées par implantation ionique.

**Revendications**

1. Procédé de réalisation d'une prise de contact électrique sur un substrat (1) en HgCdTe de conductivité P, selon lequel:
   - on dépose au moins une couche isolante (3) sur ledit substrat,
   - on grave par un bombardement ionique (11) la couche isolante (3) sur toute son épaisseur de façon à réaliser une ouverture (13) dans la couche isolante,
   - on effectue un traitement thermique du substrat recouvert par la couche isolante, de façon à au moins compenser la diminution de conductivité P induite par le bombardement ionique dans une partie (14) du substrat (1) en regard de l'ouverture (13) réalisée dans la couche isolante,
   - on forme un plot conducteur (25) dans l'ouverture (13) réalisée dans la couche isolante pour réaliser une prise de contact électrique avec la partie (14) du substrat en regard de ladite ouverture (13).

2. Procédé de réalisation selon la revendication 1, caractérisé en ce qu'on effectue un recuit du substrat (1), avant de déposer la couche isolante (3), afin d'ajuster la conductivité P du substrat à une valeur souhaitée, le traitement thermique et le recuit étant effectués à la même température.

3. Procédé de réalisation selon l'une quelconque des revendications 1 et 2, caractérisé en ce que l'on dépose une première et une deuxième couches isolantes (3a, 3b) sur le substrat.

4. Procédé de réalisation selon l'une quelconque des revendications 1 à 3, caractérisé en ce que l'ouverture (13) de la couche isolante (3) étant réalisée par bombardement ionique, à travers un masque en résine (7) déposé sur ladite couche et comportant une ouverture (9) en regard de l'ouverture à réaliser dans ladite couche, on traite thermiquement le masque pour faire fluer la résine dans l'ouverture (9) dudit masque, avant de réaliser l'ouverture de la couche isolante.

5. Procédé de réalisation selon l'une quelconque des revendications 1 à 4, caractérisé en ce qu'on effectue le traitement thermique sous atmosphère de mercure.

6. Procédé de réalisation selon l'une quelconque des revendications 1 à 4, caractérisé en ce qu'on effectue le traitement thermique après avoir déposé sous vide, sur la partie (14) du substrat (1) en regard de l'ouverture (13) réalisée dans la couche isolante, un matériau isolant (18), celui-ci étant éliminé après ledit traitement thermique.

7. Procédé de réalisation selon l'une quelconque des revendications 1 à 4, caractérisé en ce qu'on effectue le traitement thermique après avoir déposé sous vide, sur la partie (14) du substrat (1) en regard de l'ouverture (13) réalisée dans la couche isolante, un matériau métallique comprenant des atomes à caractère P, pour obtenir une conductivité P dans ladite partie (14) du substrat, supérieure à celle du reste du substrat.

8. Procédé de réalisation selon l'une quelconque des revendications 1 à 7, caractérisé en ce que le traitement thermique est effectué à une température supérieure à 200°C et égal à la température ayant fixé la conductivité P du substrat.

9. Procédé de fabrication d'une diode N/P à partir d'un substrat en HgCdTe de conductivité P, selon lequel, successivement :
   - on dépose au moins une couche isolante (3) sur ledit substrat,
   - on grave par un bombardement ionique (11) la couche isolante (3) sur toute son épaisseur de façon à réaliser une première ouverture (13) dans la couche isolante,
   - on effectue un traitement thermique du substrat recouvert par la couche isolante (3) de façon à au moins compenser la diminution de conductivité P induite par le bombardement ionique dans une première partie (14) du substrat (1) en regard de la première ouverture (13),
   - on effectue dans le susbstrat traité thermiquement, à travers la couche isolante, une implantation (19) ionique pour former dans le substrat une deuxième partie (22) de conductivité N, distante de la première partie (14),
   - on grave par un bombardement ionique (20) la couche isolante sur tout son épaisseur de façon à réaliser une deuxième ouverture (21) dans la couche isolante (3) en regard de la deuxième partie, et
   - on forme des plots conducteurs (25, 27) dans les première et deuxième ouvertures (13, 21) de la couche isolante (3), pour réaliser une prise de contact électrique avec chacune desdites première et deuxième parties du substrat (14, 22) en regard desdites ouvertures.

10. Procédé de fabrication selon la revendication 9, caractérisé en ce qu'on effectue un recuit du substrat (1), avant de déposer la couche isolante (3), pour ajuster la conductivité P du substrat à une valeur souhaitée, le traitement thermique et le recuit étant effectués à la même température.

11. Procédé de fabrication selon l'une quelconque des revendications 9 et 10, caractérisé en ce qu'on effectue le traitement thermique après avoir déposé sous vide, sur la première partie (14) du substrat (1) en regard de la première ouverture (13) réalisée dans la couche isolante (3), un matériau métallique comprenant des atomes à caractère P, pour obtenir une conductivité P dans ladite première partie (14) du substrat, supérieure à celle du reste du substrat.

12. Procédé de fabrication selon l'une quelconque des revendications 9 à 11, caractérisé en ce que le traitement thermique est effectué à une température supérieure à 200°C et égal à la température ayant fixé la conductivité P du substrat.

13. Procédé de fabrication selon l'une quelconque des revendications 9 à 12, caractérisé en ce que la première ouverture (13) de la couche isolante (3) étant réalisée par bombardement ionique à travers un masque en résine (7) déposée sur ladite couche et comportant une ouverture (9) en regard de la première ouverture réaliser dans ladite couche, on traite thermiquement ledit masque pour faire fluer la résine dans l'ouverture (9) dudit masque (7) avant de réaliser ladite première ouverture.

14. Procédé de fabrication selon l'une quelconque des revendications 9 à 13, caractérisé en ce que la deuxième ouverture (21) de la couche isolante étant réalisée par bombardement ionique, à travers un masque en résine (16) déposé sur ladite couche et comportant une ouverture (23) en regard de la deuxième ouverture à réaliser dans ladite couche, on traite thermiquement ledit masque pour faire fluer la résine dans l'ouverture dudit masque avant de réaliser ladite deuxième ouverture.

## Claims

1. Process for the production of an electric contact on a HgCdTe substrate (1) of P conductivity, wherein at least one insulating layer (3) is deposited on said substrate, the entire thickness of the insulating layer (3) is etched by ion bombardment (11) so as to produce an opening (13) in said insulating layer, the substrate covered by the insulating layer undergoes a heat treatment, so as to at least compensate the P conductivity reduction induced by the ion bombardment in that part (14) of the substrate (1) facing the opening (13) made in the insulating layer and a conductive pad (25) is formed in the opening (13) made in the insulating layer to bring about an electric contact with that part (14) of the substrate facing the opening (13).

2. Production process according to claim 1, characterized in that the substrate (1) undergoes annealing prior to the deposition of the insulating layer (3), in order to adjust the P conductivity of the substrate to a desired value, the heat treatment and annealing being performed at the same temperature.

3. Production process according to either of the claims 1 and 2, characterized in that the first and second insulating layers (3a, 3b) are deposited on the substrate.

4. Production process according to any one of the claims 1 to 3, characterized in that the opening (13) in the insulating layer (3) is produced by ion bombardment through a resin mask (7) deposited on the said layer and having an opening facing the opening (9) to be produced in said layer, the mask is thermally treated in order to make the resin flow into the opening (9) of said mask before making the opening in the insulating layer.

5. Production process according to any one of the claims 1 to 4, characterized in that the heat treatment is performed under a mercury atmosphere.

6. Production process according to any one of the claims 1 to 4, characterized in that the heat treatment is performed following the vacuum deposition on that part (14) of the substrate (1) facing the opening (13) made in the insulating layer of an insulating material (18), the latter being eliminated after said heat treatment.

7. Production process according to any one of the claims 1 to 4, characterized in that the heat treatment is carried out following the vacuum deposition on that part (14) of the substrate (1) facing the opening (13) made in the insulating layer of a metallic material incorporating atoms having a P character, in order to obtain a P conductivity in said substrate part (14), which exceeds that of the remainder of the substrate.

8. Production process according to any one of the claims 1 to 7, characterized in that the heat treatment is performed at a temperature exceeding 200°C and equal to the temperature which has fixed the P conductivity of the substrate.

9. Process for producing a N/P diode from a P conductivity, HgCdTe substrate, wherein, successively, at least one insulating layer (3) is deposited on said substrate, the entire thickness of the insulating layer (3) is etched by ion bombardment (11) in order to produce a first opening (13) in the insulating layer, a heat treatment is carried out on the substrate covered by the insulating layer (3), so as to at least compensate the P conductivity reduction induced by the ion bombardment in a first part (14) of the substrate (1) facing the first opening (13), ion implantation (19) takes place in the heat treated substrate through the insulating layer in order to form in said substrate a second part (22) of N conductivity spaced from the first part (14), the entire thickness of the insulating layer is etched by ion bombardment (20), so as to produce a second opening (21) in the insulating layer (3) facing the second part and conductive pads (25, 27) are formed in the first and second openings (13, 21) of the insulating layer (3), in order to produce an electric contact with each of said first and second parts of the substrate (14, 22) facing said openings.

10. Production process according to claim 9, characterized in that the substrate (1) is annealed prior to the deposition of the insulating layer (3), in order to adjust the P conductivity of the substrate to a desired value, the heat treatment and annealing being performed at the same temperature.

11. Production process according to either of the claims 9 and 10, characterized in that the heat treatment is performed following the vacuum deposition on the first part (14) of the substrate (1) facing the first opening (13) made in the insulating layer (3) of a metallic material having atoms with a P character, in order to obtain a P conductivity in said first part (14) of the substrate exceeding that of the remainder of the substrate.

12. Production process according to any one of the claims 9 to 11, characterized in that the heat treatment is performed at a temperature exceeding 200°C and equal to the temperature which has fixed the P conductivity of the substrate.

13. Production process according to any one of the claims 9 to 12, characterized in that as the first opening (13) of the insulating layer (3) is produced by ion bombardment through a resin mask (7) deposited on said layer and having an opening (9) facing the first opening to be produced in said layer, said mask is thermally treated in order to bring about a flow of resin into the opening (9) of said mask (7) prior to the production of said first opening.

14. Production process according to any one of the claims 9 to 13, characterized in that the second opening (21) of the insulating layer is produced by ion bombardment through a resin mask (16) deposited on said layer and having an opening (23) facing the second opening to be produced on the said layer, so that said mask undergoes a heat treatment in order to make the resin flow into the opening of the mask before producing the second opening.

## Patentansprüche

1. Verfahren zum Herstellen eines elektrischen Kontakts auf einem Substrat (1) aus HgCdTe mit P-Leitfähigkeit, demzufolge man:
   - wenigstens eine Isolierschicht (3) auf dem Substrat abscheidet,
   - mit einer Ionenbestrahlung (11) die Isolierschicht (3) in ihrer gesamten Dicke ätzt, so daß eine Öffnung (13) in der Isolierschicht hergestellt wird,
   - eine thermische Behandlung des mit der Isolierschicht bedeckten Substrat durchführt, so daß wenigsten die durch die Ionenbestrahlung in einem Teil (14) des Substrats (1) gegenüber der in der Isolierschicht ausgeführten Öffnung (13) verursachte Verringerung der p-Leitfähigkeit kompensiert wird,
   - ein Kontaktstück (25) in der in der Isolierschicht gebildeten Öffnung (13) formt, um einen elektrischen Kontakt mit dem Teil (14) des Substrats gegenüber dieser Öffnung (13) zu bilden.

2. Herstellungsverfahren nach Anspruch 1, dadurch gekennzeichnet, daß man vor der Abscheidung der Isolierschicht (3) eine Temperung des Substrats (1) durchführt, um die P-Leitfähigkeit des Substrats auf einen gewünschten Wert einzustellen, wobei die thermische Behandlung und die Temperung bei derselben Temperatur durchgeführt werden.

3. Herstellungsverfahren nach einem der Ansprüche 1 und 2, dadurch gekennzeichnet, daß man eine erste und eine zweite Isolierschicht (3a, 3b) auf dem Substrat abscheidet.

4. Herstellungsverfahren nach einem der Ansprüche 1 bis 3, dadurch gekennzeichnet, daß man, wenn die Öffnung (13) in der Isolierschicht (3) durch Ionenbestrahlung durch eine auf dieser Schicht abgeschiedene Photolackmaske (7) mit einer Öffnung (9) gegenüber der in dieser Schicht zu bildenden Öffnung gebildet wird, die Maske thermisch behandelt, um den Photolack vor dem Bilden der Öffnung in der Isolierschicht in die Öffnung (9) der Maske fließen zu lassen.

5. Herstellungsverfahren nach einem der Ansprüche 1 bis 4, dadurch gekennzeichnet, daß man die thermische Behandlung unter Quecksilberatmosphäre durchführt.

6. Herstellungsverfahren nach einem der Ansprüche 1 bis 4, dadurch gekennzeichnet, daß man die thermische Behandlung nach dem Abscheiden unter Vakuum eines isolierenden Materials (18) auf den gegenüber der in der Isolierschicht gebildeten Öffnung (13) liegenden Teil (14) des Substrats (1) durchführt, wobei dieses Material nach der thermischen Behandlung entfernt wird.

7. Herstellungsverfahren nach einem der Ansprüche 1 bis 4, dadurch gekennzeichnet, daß man die thermische Behandlung nach dem Abscheiden unter Vakuum eines metallischen Materials mit Atomen vom P-Typ auf den gegenüber der in der Isolierschicht gebildeten Öffnung (13) liegenden Teil (14) des Substrats (1) durchführt, um eine P-Leitfähigkeit in diesem Teil (14) des Substrats zu erhalten, die höher ist als die im Rest des Substrats.

8. Herstellungsverfahren nach einem der Ansprüche 1 bis 7, dadurch gekennzeichnet, daß die thermische Behandlung bei einer Temperatur über $200\,^{\circ}C$ und gleich der Temperatur, die die P-Leitfähigkeit des Substrats festgelegt hat, durchgeführt wird.

9. Verfahren zum Herstellen einer N/P-Diode ausgehend von einem Substrat (1) aus HgCdTe mit P-Leitfähigkeit, demzufolge man:
   - wenigstens eine Isolierschicht (3) auf dem Substrat abscheidet,
   - mit einer Ionenbestrahlung (11) die Isolierschicht (3) in ihrer gesamten Dicke ätzt, so daß eine erste Öffnung (13) in der Isolierschicht hergestellt wird,
   - eine thermische Behandlung des mit der Isolierschicht bedeckten Substrat durchführt, so daß wenigsten die durch die Ionenbestrahlung in einem ersten Teil (14) des Substrats (1) gegenüber der in der Isolierschicht ausgeführten ersten Öffnung (13) verursachte Verringerung der P-Leitfähigkeit kompensiert wird,

- in dem thermisch behandelten Substrat durch die Isolierschicht eine Ionenimplantation (19) durchführt, um in dem Substrat einen zweiten Teil (22) mit N-Leitfähigkeit herzustellen, der von dem ersten Teil (14) entfernt ist,
- durch Ionenbestrahlung (20) die Isolierschicht (3) in ihrer gesamten Dicke ätzt, so daß eine zweite Öffnung (21) in der Isolierschicht (3) gegenüber dem zweiten Teil hergestellt wird,
- Kontaktstücke (25,27) in die in der Isolierschicht gebildeten ersten und zweiten Öffnungen (13, 21) formt, um einen elektrischen Kontakt mit jedem der ersten und zweiten Teile (14,22) des Substrats gegenüber den Öffnungen zu bilden.

10. Herstellungsverfahren nach Anspruch 9, dadurch gekennzeichnet, daß man vor der Abscheidung der Isolierschicht (3) eine Temperung des Substrats (1) durchführt, um die P-Leitfähigkeit des Substrats auf einen gewünschten Wert einzustellen, wobei die thermische Behandlung und die Temperung bei derselben Temperatur durchgeführt werden.

11. Herstellungsverfahren nach einem der Ansprüche 9 und 10, dadurch gekennzeichnet, daß man die thermische Behandlung nach dem Abscheiden unter Vakuum eines metallischen Materials mit Atomen vom P-Typ auf den gegenüber der in der Isolierschicht gebildeten ersten Öffnung (13) liegenden ersten Teil (14) des Substrats (1) durchführt, um eine P-Leitfähigkeit in dem ersten Teil (14) des Substrats zu erhalten, die höher ist als die im Rest des Substrats.

12. Herstellungsverfahren nach einem der Ansprüche 9 bis 11, dadurch gekennzeichnet, daß die thermische Behandlung bei einer Temperatur über 200°C und gleich der Temperatur, die die P-Leitfähigkeit des Substrats festgelegt hat, durchgeführt wird.

13. Herstellungsverfahren nach einem der Ansprüche 9 bis 12, dadurch gekennzeichnet, daß man, wenn die erste Öffnung (13) in der Isolierschicht (3) durch Ionenbestrahlung durch eine auf dieser Schicht abgeschiedene Photolackmaske (7) mit einer Öffnung (9) gegenüber der in dieser Schicht zu bildenden ersten Öffnung gebildet wird, die Maske thermisch behandelt, um den Photolack vor dem Bilden der ersten Öffnung in der Isolierschicht in die Öffnung (9) der Maske fließen zu lassen.

14. Herstellungsverfahren nach einem der Ansprüche 9 bis 13, dadurch gekennzeichnet, daß man, wenn die zweite Öffnung (21) in der Isolierschicht (3) durch Ionenbestrahlung durch eine auf dieser Schicht abgeschiedene Photolackmaske (16) mit einer Öffnung (23) gegenüber der in dieser Schicht zu bildenden zweiten Öffnung gebildet wird, die Maske thermisch behandelt, um den Photolack vor dem Bilden der zweiten Öffnung in der Isolierschicht in die Öffnung der Maske fließen zu lassen.

FIG. 1a

FIG. 1b

FIG. 1c

FIG. 1d

FIG. 1e

FIG. 1f

FIG. 1g

FIG. 1h

FIG. 1i

FIG. 2